# EUROPÄISCHE PATENTSCHRIFT

(11) **EP 2 926 455 B1**
(45) Veröffentlichungstag und Bekanntmachung des Hinweises auf die Patenterteilung: **09.05.2018**
(21) Anmeldenummer: 13702786.8
(22) Anmeldetag: 29.01.2013
(51) Int. Cl.: H01H 33/59, H03K 17/00, H01H 9/52, H01H 9/54

(54) **VORRICHTUNG ZUM SCHALTEN VON GLEICHSTRÖMEN IN ABZWEIGEN EINES GLEICHSPANNUNGSNETZKNOTENS**
APPARATUS FOR SWITCHING DIRECT CURRENTS IN BRANCHES OF A DC VOLTAGE GRID NODE
DISPOSITIF D'INTERRUPTION DE COURANTS CONTINUS DANS DES BRANCHES DE DÉRIVATION D'UN NOEUD DE RÉSEAU DE TENSION CONTINUE

(43) Veröffentlichungstag der Anmeldung: 07.10.2015
(73) Patentinhaber: Siemens Aktiengesellschaft, 80333 München (DE)
(72) Erfinder: ERGIN, Dominik, 91083 Baiersdorf (DE); KNAAK, Hans-Joachim, 91054 Erlangen (DE)
(86) Internationale Anmeldenummer: PCT/EP2013/051669
(87) Internationale Veröffentlichungsnummer: WO 2014/117813

(56) Entgegenhaltungen:
- WO-A1-2011/057675
- DE-U1-202012 100 023

## Beschreibung

Die Erfindung betrifft eine Vorrichtung zum Schalten von Gleichströmen in Abzweigen eines Gleichspannungsnetzknotens mit einem ersten Abschaltzweig, in dem eine Leistungsschalteinheit angeordnet ist, die eine Reihenschaltung von zweipoligen Submodulen mit wenigstens einem ein- und abschaltbaren Leistungshalbleiterschalter aufweist, einem parallel zum Abschaltzweig schaltbaren Betriebsstromzweig, in dem ein mechanischer Schalter angeordnet und der mit einem Abzweig des Gleichspannungsnetzknotens verbindbar ist und mit Kommutierungsmittel zum Kommutieren des Gleichstromes von dem Betriebsstromzweig in den Abschaltzweig.

Eine solche Vorrichtung ist aus der WO 2011/057675 A1 bereits bekannt. Der dort beschriebene Gleichspannungsleistungsschalter weist einen Betriebsstrompfad mit einem mechanischen Schalter sowie einen Abschaltzweig auf, der dem Betriebsstrompfad parallel geschaltet ist. In dem Abschaltzweig ist eine Reihenschaltung von Leistungshalbleiterschaltern angeordnet, denen jeweils eine Freilaufdiode gegensinnig parallel geschaltet ist. Die aus Leistungshalbleiterschaltern und Freilaufdiode bestehenden Schalteinheiten sind antiseriell angeordnet, wobei die abschaltbaren Leistungshalbleiterschalter in Reihe angeordnet sind und für jeden Leistungshalbleiterschalter ein entsprechender Leistungshalbleiterschalter mit entgegengesetzter Durchlassrichtung vorgesehen ist. Auf diese Art und Weise kann der Strom in beiden Richtungen im Abschaltzweig sowohl geführt als auch unterbrochen werden. Im Betriebsstrompfad ist hingegen neben dem mechanischen Schalter ein im Hinblick auf die Leistungsschalteinheit weniger aufwändiger elektronischer Hilfsschalter in Reihe zum mechanischen Schalter angeordnet. Im Normalbetrieb fließt der Strom über den Betriebsstrompfad und somit über den elektronischen Hilfsschalter sowie den geschlossenen mechanischen Schalter, da die Leistungshalbleiterschalter des Abschaltzweiges einen im Vergleich zum Betriebsstrompfad erhöhten Widerstand für den Gleichstrom darstellen. Zum Unterbrechen beispielsweise eines Kurzschlussstromes wird der elektronische Hilfsschalter in seine Trennstellung überführt. Hierdurch steigt der Widerstand im Betriebsstrompfad an, so dass der Gleichstrom in den Abschaltzweig kommutiert. Der schnelle mechanische Schalter kann daher stromlos geöffnet werden. Der über den Abschaltzweig geführte Kurzschlussstrom kann durch die Leistungshalbleiterschalter unterbrochen werden. Zur Aufnahme der im Gleichspannungsnetz gespeicherten und beim Schalten abzubauenden Energie sind Ableiter vorgesehen, die den Leistungshalbleiterschaltern des Abschaltzweiges jeweils parallel geschaltet sind.

Der weltweit steigende Energiebedarf und die gleichzeitig gewünschte Verringerung des CO₂-Ausstoßes machen so genannte erneuerbare Energien immer attraktiver. Quellen erneuerbarer Energien sind beispielsweise seeseitig aufgestellte Windkraftanlagen oder aber Photovoltaikkraftanlagen in sonnenreichen Wüstengegenden. Um die so erzeugte Energie ökonomisch nutzen zu können, kommt der Anbindung der erneuerbaren Energiequellen an ein Landversorgungsnetz eine immer größere Bedeutung zu. Vor diesem Hintergrund wird die Errichtung und der Betrieb eines vermaschten Gleichspannungsnetzes immer stärker diskutiert. Voraussetzung hierfür ist jedoch, dass Kurzschlussströme, die in einem solchen vermaschten Gleichspannungsnetz auftreten können, schnell und zuverlässig abgeschaltet werden können.

In der Vergangenheit wurden verschiedene Konzepte für Gleichspannungsleistungsschalter diskutiert. Bei dem gattungsgemäßen Schalterkonzept handelt es sich um ein so genanntes hybrides Schalterkonzept, bei dem die Vorteile von mechanischen und leistungselektronischen Schaltern gemeinsam ausgenutzt werden. Hierbei wird generell zwischen uni- und bidirektionalen Schalterkonzepten unterschieden. Ein unidirektional wirkender Schalter muss Ströme in beide Richtungen führen, aber nur in einer Schaltung abschalten können, während ein bidirektionaler Schalter Ströme in beiden Richtungen führen und abschalten kann.

Der eingangs genannten Vorrichtung haftet der Nachteil an, dass diese aufgrund der erforderlichen Leistungselektronik insbesondere bei einer Ausgestaltung als bidirektionaler Schalter kostenintensiv ist. Insbesondere bei einem Einsatz in Netzknotenpunkten, die aus Redundanzgründen oft als Doppelsammelschienensystem realisiert sind, steigen die Kosten weiter an.

Aufgabe der Erfindung ist es daher, eine Vorrichtung der eingangs genannten Art bereitzustellen, die insbesondere in Abzweigen eines Gleichspannungsnetzknotens kostengünstig eingesetzt werden kann.

Die Erfindung löst diese Aufgabe dadurch, dass wenigstens ein weiterer Betriebsstromzweig vorgesehen ist, der dem ersten Abschaltzweig parallel schaltbar ist, wobei jeder Betriebsstromzweig über einen Parallelschalter dem Abschaltzweig parallel schaltbar ist.

Die Erfindung basiert auf der Idee, dass zum Schalten von Strömen in einem Gleichspannungsnetzknoten mit mehreren Abzweigen es keineswegs notwendig ist, eine der Anzahl der Abzweige entsprechende Anzahl an Gleichspannungsschaltern vorzusehen, wobei jeder Gleichspannungsschalter mit seinem Abschalt- und Betriebsstromzweig ausgerüstet ist. Vielmehr ist es im Rahmen der Erfindung ausreichend, lediglich einen Abschaltzweig bereitzustellen und eine der Anzahl der Abzweige entsprechende Anzahl von Betriebsstromzweigen vorzusehen. Die Betriebsstromzweige sind bei Normalbetrieb beispielsweise nur an einer Stelle mit der Leistungsschalteinheit des Abschaltzweiges verbunden. Erst im Fehlerfall dient ein Parallelschalter, der dem Betriebsstromzweig fest zugeordnet ist, zu dessen Verbindung mit dem Betriebsstromzweig, so dass jede Klemme des mechanischen Schalters des Betriebsstromzweiges mit einer anderen Klemme der Leistungsschalteinheit des Abschaltzweiges verbunden ist. Mit anderen Worten dient der Parallelschalter zum Parallelschalten des den Fehlerstrom führenden Betriebsstromzweiges mit dem Abschaltzweig. Auf diese Weise kann das dem fehlerbehafteten Betriebsstromzweig zugeordnete Kommutierungsmittel die Kommutierung des Fehlerstromes auf den Abschaltzweig bewirken, so dass die Leistungsschalteinheit, die allen Betriebsstromzweigen gemeinsam ist, das Abschalten des Fehlerstromes vornehmen kann. Erfindungsgemäß ist daher unabhängig von der Anzahl der Abzweige eines Gleichspannungsnetzknotens lediglich eine Leistungsschalteinheit oder zumindest eine reduzierte Anzahl von Leistungsschalteinheiten erforderlich. Die Kosten der erfindungsgemäßen Vorrichtung sind daher erheblich reduziert. Im Betriebsstromzweig sind lediglich ein mechanischer Schalter und gegebenenfalls ein Kommutierungsmittel anzuordnen. Diese beide Bauteile sind wesentlich kostengünstiger als die im Abschaltzweig angeordnete Leistungsschalteinheit, die so dimensioniert ist, dass diese die hohen Leistungen schalten kann, die im Fehlerfall im Bereich der Hochspannungsgleichstromübertragung auftreten können.

Die im Rahmen der Erfindung eingesetzten mechanischen Schalter sind als schnelle Schalter ausgestaltet und weisen vorzugsweise eine Schaltzeit von weniger als 10 Millisekunden aufweisen. Der oder die mechanischen Schalter sind beispielsweise eine Vakuumschaltröhre oder eine Reihenschaltung von Vakuumröhren. Dies gilt beispielsweise für den im Betriebsstromzweig angeordneten mechanischen Schalter. Auch der Parallelschalter kann ein mechanischer Schalter und bevorzugt ein, wie oben beschrieben, schneller mechanischer Schalter sein.

Die Ausgestaltung der Leistungsschalteinheit ist im Rahmen der Erfindung grundsätzlich beliebig. Dies gilt auch für die Kommutierungsmittel. Die Submodule der Leistungsschalteinheit müssen jedoch in der Lage sein, die hohen Fehlerströme sicher abzuschalten und darüber hinaus die dabei frei werdende Energie kontrolliert abzubauen. Die Kommutierungsmittel sind beispielsweise aktive Kommutierungsmittel und so ausgestaltet, dass sie einen hohen Kreisstrom in der aus dem Abschaltzweig und dem parallelen Betriebsstromzweig gebildeten Masche erzeugen. Dieser Kreisstrom ist dem in dem mechanischen Schalter fließenden Strom entgegengesetzt, so dass dieser nahezu stromlos geöffnet werden kann. Als aktive Kommutierungsmittel kommen beispielsweise zweipolige Submodule in Betracht, die als Voll- oder Halbbrückenschaltung ausgebildet sind. Jedes dieser Submodule weist einen Energiespeicher z.B. in Gestalt eines Kondensators auf, wobei dem Energiespeicher eine oder bei der Vollbrücke zwei Reihenschaltungen von ansteuerbaren Leistungshalbleiterschaltern parallel geschaltet sind. Die Submodulanschlussklemmen sind entweder beide mit dem Potentialpunkt zwischen den Leistungshalbleitern verbunden. Bei der Halbbrückenschaltung liegt jedoch eine Submodulanschlussklemme direkt an einem Pol des unipolaren Energiespeichers an. Die aktiven Kommutierungsmittel können beispielsweise Teil der Leistungsschalteinheit sein, die aus identisch oder unterschiedlich ausgestalteten Submodulen besteht.

Zum Erfassen des Stromflusses ist beispielsweise im Betriebsstromzweig ein Stromsensor vorgesehen. Selbstverständlich kann auch die Spannung im Betriebsstromzweig gegenüber dem Erdpotenzial und/oder die über den Schalter abfallende Spannung überwacht werden. Dies gilt entsprechend auch für den Abschaltzweig. Die Kommutierungsmittel umfassen vorteilhafterweise eine Steuerungs- oder Regelungseinheit, die mit dem Strommesssensor des Betriebsstromzweiges verbunden ist. Die vom Strommesssensor erzeugten Strommesswerte werden an die Regelungseinheit übertragen, welche die empfangenen Strommesswerte auswertet, um festzustellen, ob ein zuvor festgelegtes Eingriffskriterium vorliegt. Ein solches Eingriffskriterium ist beispielsweise ein zu großer Stromanstieg (di/dt) oder wenn die gemessenen Stromwerte einen Stromschwellenwert ein vorgesehenes Zeitfenster lang überschreiten. Grundsätzlich sind jedoch beliebige Verknüpfungen mit weiteren Messwerten von anderen Messgeräten, die beispielsweise in anderen Gleichspannungsnetzknoten angeordnet sind, oder weitere Kriterien im Rahmen der Erfindung möglich.

Wird ein solches Eingriffskriterium festgestellt, wird das Abschalten des Fehlerstromes in Gang gesetzt. Dies erfolgt beispielsweise durch Öffnen eines elektronischen Hilfsschalters im Betriebsstromzweig als Kommutierungsmittel und des in Reihe hierzu geschalteten mechanischen Schalters, so dass der Strom in die Submodule der Leistungsschalteinheit kommutiert.

Vorteilhafterweise weisen die Submodule der Leistungsschalteinheit zumindest teilweise jeweils einen ein- und abschaltbaren Leistungshalbleiterschalter und eine gegensinnig parallel hierzu geschaltete Freilaufdiode auf. Alternativ hierzu kann jedes Submodul auch einen einzigen rückwärts leitfähigen Leistungshalbleiterschalter aufweisen. Als Leistungshalbleiterschalter kommen beispielsweise IGBTs, GTOs oder dergleichen in Betracht. In der Regel weist ein Leistungshalbleiterschalter mehrere in einem Gehäuse angeordnete Leistungshalbleiterschalterchips auf. Zur Verbindung der Lastanschlüsse der Leistungshalbleiterschalterchips dienen beispielsweise Bonddrähte. Abweichend hiervon können jedoch auch druckkontaktierte Leistungshalbleiterschalter im Rahmen der Erfindung eingesetzt werden, bei denen die Leistungshalbleiterschalterchips lastanschlussseitig über eine Druckkontaktierung miteinander verbunden sind. Solche Leistungshalbleiterschalter sind dem Fachmann jedoch bekannt, so dass auf deren Ausgestaltung hier nicht genauer eingegangen zu werden braucht.

Gemäß einer bevorzugten Weiterbildung der Erfindung bilden die Submodule der Leistungshalbleitereinheit zwei Gruppen mit jeweils gleich orientierten Durchlassrichtungen ihrer Leistungshalbleiterschalter aus, wobei die Leistungshalbleiterschalter der einen Gruppe entgegengesetzt zu den Leistungshalbleiterschaltern der anderen Gruppe orientiert sind. Gemäß dieser vorteilhaften Weiterentwicklung ist ein bidirektionaler Schalter bereitgestellt. Ein bidirektionaler Schalter kann den Strom nicht nur in beiden Richtungen führen, sondern auch in beiden Richtungen sicher abgeschalten. Fließt der Strom in die erste Richtung, werden die Leistungshalbleiterschalter der ersten Gruppe angesteuert, deren Durchlassrichtung der Richtung des zu schaltenden Stromes entspricht. Fließt der Strom in die entgegengesetzte zweite Richtung, kommen die Leistungshalbleiterschalter der zweiten Gruppe zum Einsatz, wohingegen die erste Gruppe den Strom mittels ihrer Freilaufdioden nur führen kann.

Gemäß einer hiervon abweichenden Ausgestaltung der Erfindung ist es auch möglich, dass die Submodule jeweils einen Energiespeicher aufweisen und über eine Leistungshalbleiterschaltung verfügen, die gemeinsam eine so genannte Halbbrücken- oder Vollbrückenschaltung ausbilden. Bei einer Halbbrückenschaltung ist dem Energiespeicher, beispielsweise einem Kondensator, eine Reihenschaltung aus zwei Leistungshalbleiterschaltern parallel geschaltet. Eine Submodulanschlussklemme des zweipoligen Submoduls ist mit dem Potenzialpunkt zwischen den Leistungshalbleiterschaltern der Reihenschaltung verbunden, während die andere Submodulanschlussklemme direkt mit einem der Pole des Energiespeichers verbunden ist. Bei einer Vollbrückenschaltung sind zwei Reihenschaltungen von jeweils zwei Leistungshalbleiterschaltern vorgesehen, wobei eine Submodulanschlussklemme mit dem Potenzialpunkt zwischen den Leistungshalbleiterschaltern der ersten Reihenschaltung und die zweite Submodulanschlussklemme mit dem Potenzialpunkt zwischen denn Leistungshalbleiterschaltern der zweiten Reihenschaltung verbunden ist. Die Vollbrückenschaltung weist somit insgesamt vier Leistungshalbleiterschalter auf, während die Halbbrückenschaltung mit zwei Leistungshalbleiterschaltern auskommt. Die Vollbrückenschaltung kann jedoch an den beiden Submodulanschlussklemmen entweder die an dem Energiespeicher abfallende Energiespeicherspannung, eine Nullspannung oder im Gegensatz zur Halbbrückenschaltung auch die inverse Energiespeicherspannung erzeugen. Sind die Submodule der Leistungsschalteinheit jeweils als Halbbrückenschaltung ausgestaltet, ist eine Orientierung der Halbbrückenschaltung in dem Sinne vorzunehmen, dass der Strom in der gewünschten Richtung wirksam und zuverlässig abgeschaltet werden kann. Entsprechende Überlegungen sind bei der symmetrischen Vollbrückenschaltung nicht notwendig.

Zweckmäßigerweise weist die Leistungsschalteinheit Varistoren und/oder Ableiter in Parallelschaltung zu wenigstens einem Submodul auf. Die Varistoren oder Ableiter oder vergleichbare nichtlineare Widerstände übernehmen den Abbau der im Netz gespeicherten und beim Schalten frei werdenden Energie.

Gemäß einer bevorzugten Ausgestaltung weist jeder Betriebsstromzweig ein in diesem angeordnetes Kommutierungsmittel auf. Ein solches Kommutierungsmittel ist beispielsweise ein elektronischer Leistungshalbleiterschalter, der jedoch nur für geringe Spannungen ausgelegt und somit im Vergleich zur Leistungsschalteinheit kostengünstig ist. Der im Betriebsstromzweig angeordnete Leistungshalbleiterschalter wird daher hier als elektronischer Hilfsschalter bezeichnet.

Zweckmäßigerweise ist der Abschaltzweig über eine erste Sammelschiene mit jedem Betriebsstromzweig verbunden. Die Sammelschiene bildet in diesem Fall den eigentlichen Netzknoten aus, von dem die mit den Abzweigen verbindbaren Betriebsstromzweige abgehen. Ströme können daher von dem einen Abzweig über den ersten Betriebsstromzweig und die Sammelschiene in den zweiten Betriebsstromzweig und somit in den zweiten Abzweig fließen.

Gemäß einer bevorzugten Ausgestaltung der Erfindung ist jedoch eine zweite Sammelschiene vorgesehen, die über Ersatzbetriebsstromzweige mit jedem Betriebsstromzweig verbunden ist. Die Ersatzbetriebsstromzweige sind wie die Betriebsstromzweige aufgebaut und weisen daher ebenfalls einen mechanischen Schalter und vorteilhafterweise in Reihe zu dem besagten Schalter ein Kommutierungsmittel in Gestalt eines elektronischen Hilfsschalters auf, der jedoch keine großen Spannungen halten kann, sondern lediglich zur Kommutierung des Stromes dient. Der besagte mechanische Schalter ist vorteilhafterweise ein schneller mechanischer Schalter mit einer Schaltzeit von weniger als 10 Millisekunden. Hierbei kann es sich um eine Reihenschaltung von Vakuumschaltern oder -röhren handeln. Die zweite Sammelschiene ist aus Sicherheitsgründen und zu Wartungszwecken vorgesehen. Jeder Ersatzbetriebsstromzweig ist an einem Ersatzbetriebsstromverzweigungspunkt mit dem jeweiligen Betriebsstromzweig verbunden. Der mechanische Schalter und gegebenenfalls der elektronische Hilfsschalter jedes Betriebsstromzweiges sind zwischen der ersten Sammelschiene und dem Ersatzbetriebsstromverzweigungspunkt angeordnet. Die Ersatzbetriebsstromzweige sind zweckmäßigerweise mit einem Ersatzparallelschalter mit dem gleichen Abschaltzweig verbindbar, wie der Betriebsstromzweig, dem der besagte Ersatzbetriebsstromzweig zugeordnet ist. Auch der Ersatzparallelschalter ist vorteilhafterweise ein mechanischer Schalter und insbesondere ein schneller mechanischer Schalter.

Gemäß einer diesbezüglichen Weiterentwicklung sind die erste Sammelschiene und die zweite Sammelschiene jeweils über einen Sammelschienenschalter mit dem ersten Abschaltzweig verbunden. Sind beide Sammelschienen mit dem Abschaltzweig verbunden, müssen zum Schalten der zugeordnete Parallelschalter und der zugeordnete Ersatzparallelschalter geschlossen werden.

Abweichend hiervon ist es möglich, dass ein zweiter Abschaltzweig vorgesehen ist, wobei jeder Betriebsstromzweig über einen mechanischen Ersatzparallelschalter mit dem zweiten Abschaltzweig verbindbar ist.

Im Rahmen der Erfindung kann es vorteilhaft sein, dass der erste und der zweite Abschaltzweig mit der gleichen Sammelschiene verbunden sind.

Weitere Vorteile können sich ergeben, wenn der erste Abschaltzweig und der zweite Abschaltzweig über eine Anordnung mechanischer Schalter und Überbrückungszweige durch Öffnen und Schließen der mechanischen Schalter so miteinander verknüpfbar sind, dass ihre Leistungsschalteinheiten wahlweise gleich- oder gegensinnig in Reihe oder parallel geschaltet sind. Die mechanischen Schalter dieser Anordnung sind bevorzugt schnelle mechanische Schalter mit Schaltzeiten von weniger als 10 ms.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figur 1: eine vorbekannte Vorrichtung zum Schalten von Gleichströmen,
- Figur 2: einen Gleichspannungsnetzknoten mit zwei Abzweigen, in denen jeweils eine Vorrichtung gemäß Figur 1 angeordnet ist,
- Figur 3: ein Ausführungsbeispiel der erfindungsgemäßen Vorrichtung,
- Figur 4: ein weiteres Ausführungsbeispiel der erfindungsgemäßen Vorrichtung,
- Figur 5: ein weiteres Ausführungsbeispiel der erfindungsgemäßen Vorrichtung,
- Figur 6: ein weiteres Ausführungsbeispiel der erfindungsgemäßen Vorrichtung,
- Figur 7: ein weiteres Ausführungsbeispiel der erfindungsgemäßen Vorrichtung,
- Figur 8: eine Anordnung von mechanischen Schaltern und Überbrückungszweigen gemäß Figur 7 genauer,
- Figur 9: mögliche Strompfade über die in Figur 8 gezeigte Anordnung und
- Figur 10: die Vorrichtung gemäß Figur 3 mit einem Ladungswiderstand zeigen.

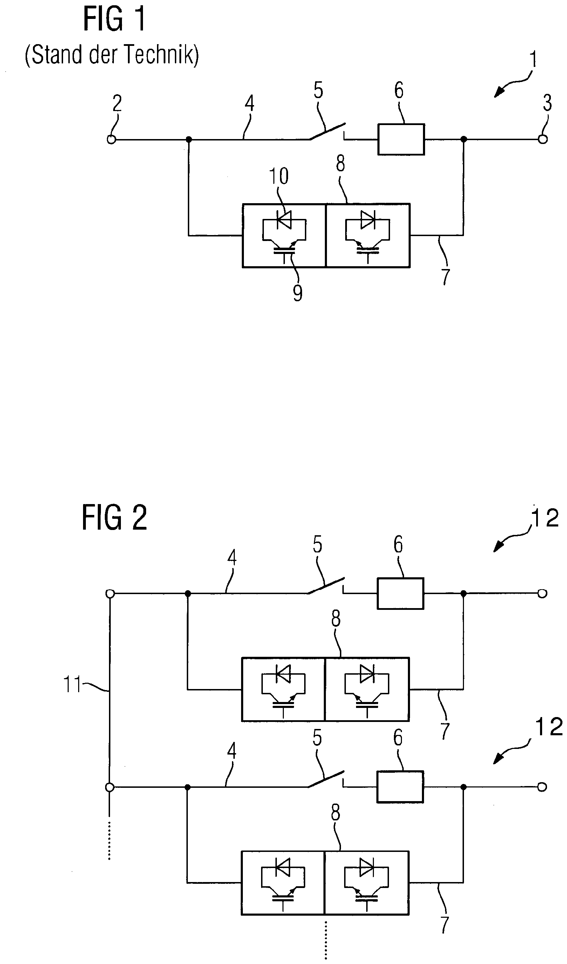

Figur 1 zeigt einen Gleichspannungsleistungsschalter 1 gemäß dem Stand der Technik. Der Gleichspannungsleistungsschalter 1 weist zwei Anschlussklemmen 2 und 3 auf, mit denen dieser seriell in einen nicht gezeigten Pol eines Gleichspannungsnetzes schaltbar ist. Zwischen den Gleichspannungsklemmen 2 und 3 erstreckt sich ein Betriebsstromzweig 4, in dem ein mechanischer Schalter 5 angeordnet ist. In Reihe zum mechanischen Schalter 5 ist ein elektronischer Hilfsschalter 6 geschaltet. Der Betriebsstromzweig 4 wird von einem Abschaltzweig 7 überbrückt, in dem eine Leistungsschalteinheit 8 angeordnet ist. Wie in der Figur schematisch angedeutet ist, verfügt die Leistungsschalteinheit 8 über eine Reihenschaltung von Submodulen, wobei jedes Submodul einen ein- und abschaltbaren Leistungshalbleiterschalter 9 in Gestalt eines IGBTs und eine gegensinnig parallel dazu geschaltete Freilaufdiode 10 aufweist. Dabei bilden die Submodule zwei Gruppen mit jeweils gleich orientierten Durchlassrichtungen ihrer Leistungshalbleiterschalter aus. Die Leistungshalbleiterschalter 9 der einen Gruppe sind entgegengesetzt zu den Leistungshalbleiterschaltern 9 der anderen Gruppe orientiert. In Figur 1 ist für jede Gruppe nur ein Leistungshalbleiterschalter in Gestalt eines IGBTs 9 dargestellt. Aufgrund der antiseriellen Anordnung der beiden Gruppen ist es möglich, Strom in beiden Richtungen über den Abschaltzweig 7 sowohl zu führen als auch zu schalten. Wäre nur eine der dargestellten Gruppen von Submodulen vorhanden, könnte der Strom zwar in beiden Richtungen über den Abschaltzweig 7 geführt, jedoch nur in einer Richtung abgeschaltet werden.

Die Leistungsschalteinheit 8 verfügt ferner über figürlich nicht dargestellte Ableiter, die den Submodulen parallel geschaltet sind. Die Ableiter dienen zum Schutz der Submodule vor zu hohen Spannungen und zum Abbau der beim Schalten frei werdenden und im Netz gespeicherten Energie.

Zum Schalten eines Fehlerstromes werden der mechanische Schalter 5 sowie der elektronische Hilfsschalter 6 nahezu gleichzeitig geöffnet. Der Strom, der beispielsweise von der Anschlussklemme 2 zur Anschlussklemme 3 fließt, kommutiert daher in den Abschaltzweig 7, wo er von der Leistungsschalteinheit 8 sicher abgeschaltet werden kann.

Figur 2 zeigt einen Gleichspannungsnetzknoten 11 mit mehreren Abzweigen 12, in denen jeweils eine Vorrichtung 1 gemäß Figur 1 angeordnet ist.

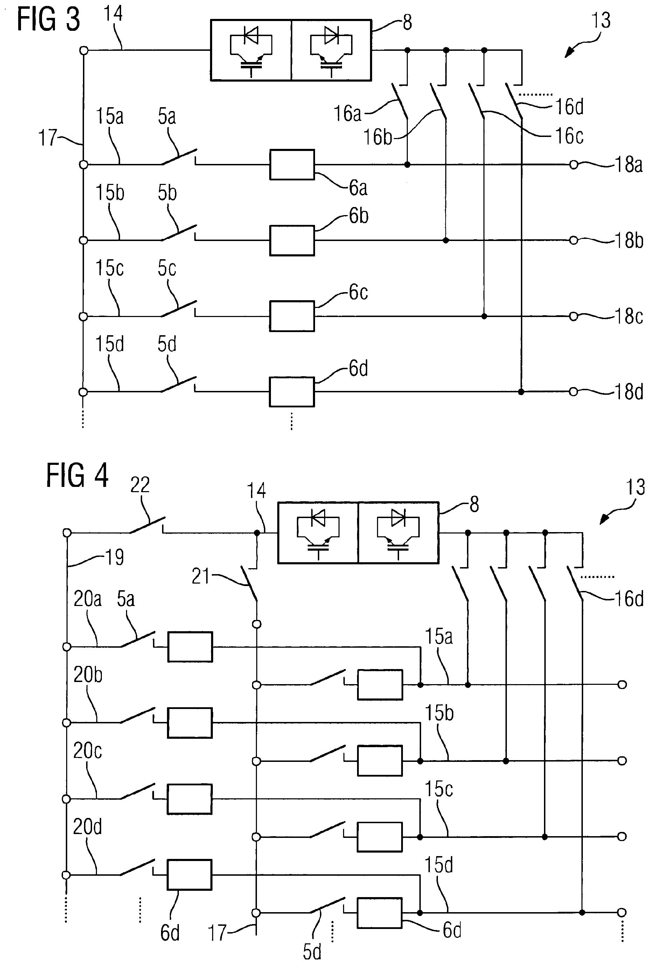

Figur 3 zeigt ein Ausführungsbeispiel der erfindungsgemäßen Vorrichtung 13. Die Vorrichtung 13 verfügt über einen ersten Abschaltzweig 14 und mehrere Betriebsstromzweige 15, die miteinander über eine Sammelschiene 17 verbunden sind. In jedem Betriebsstromzweig sind ein mechanischer Schalter 5 und in Reihe dazu ein elektronischer Hilfsschalter 6 angeordnet. Mit Hilfe mechanischer Parallelschalter 16 kann jeder Betriebsstromzweig 15 einem ersten Abschaltzweig 14 parallel geschaltet werden. Hierzu sind die mechanischen Parallelschalter 16 an der von der Sammelschiene 17 abgewandten Seite des jeweiligen mechanischen Schalters 5 und des jeweiligen elektronischen Hilfsschalters 6 angeordnet, so dass durch Schließen des mechanischen Parallelschalters 16 der jeweilige Betriebsstromzweig 15 dem ersten Abschaltzweig 14 und insbesondere der Leistungsschalteinheit 8 parallel geschaltet ist. Der in jedem Betriebsstromzweig 15 angeordnete elektronische Hilfsschalter 6 kann dann die Kommutierung eines Fehlerstromes in den ersten Abschaltzweig bewirken.

Jeder Betriebsstromzweig 15 ist ferner an seiner von der ersten Sammelschiene 17 abgewandten Seite oder Klemme mit einem Abzweiganschluss 18 ausgerüstet, der zum Anschluss eines zugeordneten Abzweiges des durch die erste Sammelschiene 17 ausgebildeten Gleichspannungsnetzknotens dient.

Um das Funktionsprinzip der erfindungsgemäßen Vorrichtung 13 zu verdeutlichen, wird der Ablauf einer Schaltung für ein exemplarisches Beispiel erläutert. Angenommen ist ein Kurzschluss in dem mit dem ersten Betriebsstromzweig 15a verbundenen Abzweigs. Durch den Kurzschluss baut sich ein Fehlerstrom in Richtung der Fehlerstelle auf, welcher von den anderen figürlich nicht dargestellten Abzweigen gespeist wird. Dem entsprechend muss der mit dem Abzweiganschluss 18a verbundene Abzweig abgeschaltet werden, um den Rest des Gleichspannungsnetzes weiterbetreiben zu können. Nach Ermittlung des abzuschaltenden Abzweiges durch den figürlich nicht dargestellten Netzschutz, werden die notwendigen Schaltbefehle durch eine ebenfalls nicht dargestellte Regelungseinheit gegeben. Zunächst wird der mechanische Parallelschalter 16a geschlossen. Hierdurch wird der Betriebsstromzweig 15a dem ersten Abschaltzweig 14 parallel geschaltet. Anschließend wird der Strom durch Ansteuerung des elektronischen Hilfsschalters 6a in den ersten Abschaltzweig 14 kommutiert. Der Öffnungsbefehl für den mechanischen Schalter 5a kann vor, während oder nach dem Schaltsignal an den elektronischen Hilfsschalter 6a erfolgen. Ist der mechanische Schalter 5a stromlos und seine Kontakte so weit voneinander getrennt, dass dieser Spannung aufnehmen kann, wird der Fehlerstrom durch die Leistungsschalteinheit 8 des Abschaltzweiges 14 abgeschaltet.

Figur 4 zeigt ein weiteres Ausführungsbeispiel der erfindungsgemäßen Vorrichtung 13, die sich von dem in Figur 3 gezeigten Ausführungsbeispiel dadurch unterscheidet, dass eine zweite Sammelschiene 19 vorgesehen ist, die über Ersatzbetriebsstromzweige 20a, 20b, 20c, 20d mit jeweils einem Betriebsstromzweig 15a, 15b, 15c beziehungsweise 15d verbunden ist. Dabei ist in jedem Ersatzbetriebsstromzweig 20a, 20b, 20c, 20d jeweils ein mechanischer Schalter 5a, 5b, 5c, 5d und in Reihe dazu ein elektronischer Hilfsschalter 6a, 6b, 6c, 6d als Kommutierungsmittel angeordnet. Die erste Sammelschiene 17 sowie die zweite Sammelschiene 19 sind über jeweils einen Sammelschienenschalter 21 beziehungsweise 22 mit dem ersten Abschaltzweig 14 verbindbar. Die zweite Sammelschiene 19 kann beispielsweise aus Redundanzgründen vorgesehen sein. Für den denkbaren Fall, dass ein Abzweig an die erste Sammelschiene 17 und die zweite Sammelschiene 19 gleichzeitig angeschlossen ist, ist es notwendig, den ersten Abschaltzweig 14 mit beiden Sammelschienen 17 und 19 durch Schließen der Sammelschienenschalter 21 und 22 zu verbinden. Durch Betätigung der elektronischen Hilfsschalter 6a sowie der mechanischen Schalter 5a des jeweiligen Ersatzbetriebsstromzweiges 20a und des Betriebsstromzweiges 15a kommutiert der Fehlerstrom in den ersten Abschaltzweig 14 und kann dort wieder durch die Leistungsschalteinheit 8 abgeschaltet werden.

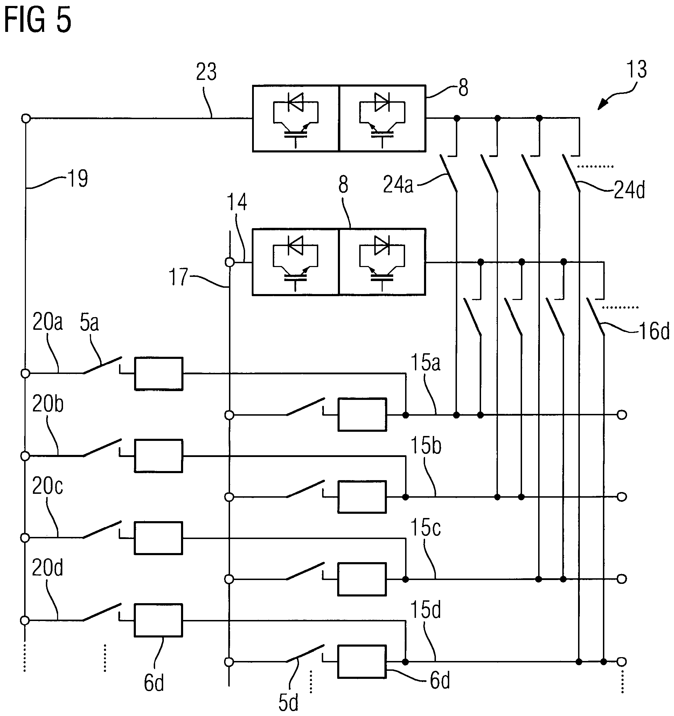

Das in Figur 5 gezeigte Ausführungsbeispiel der erfindungsgemäßen Vorrichtung 13 unterscheidet sich von dem in Figur 4 gezeigten Ausführungsbeispiel dadurch, dass ein zweiter Abschaltzweig 23 vorgesehen ist, der mit der zweiten Sammelschiene 19 verbunden ist, wohingegen der erste Abschaltzweig 14 lediglich mit der ersten Sammelschiene 17 verbunden ist. Der erste Abschaltzweig 14 und der zweite Abschaltzweig 23 weisen jeweils eine Leistungsschalteinheit 8 auf, die identisch ausgebildet sind, wobei jede Leistungsschalteinheit 8 zum Führen und Schalten von Strömen in beiden Richtungen eingerichtet ist. Die Ersatzbetriebsstromzweige 20a, 20b, 20c und 20d sind wieder mit der zweiten Sammelschiene sowie mit jeweils einem Betriebsstromzweig 15a, 15b, 15c und 15d verbunden. Jeder Betriebsstromzweig 15a, 15b, 15d und 15d ist an die erste Sammelschiene 17 angeschlossen, wobei zwischen der ersten Sammelschiene 17 und dem Verbindungspunkt mit den jeweils zugeordneten Ersatzbetriebsstromzweig 20 der jeweilige mechanische Schalter 5 sowie der jeweilige elektronische Hilfsschalter 6 angeordnet sind. Darüber hinaus sind Ersatzparallelschalter 24a, 24b, 24c, 24d vorgesehen, mit denen der jeweils zugeordneten Betriebsstromzweig 15a, 15b, 15c beziehungsweise 15d mit dem zweiten Abschaltzweig 23 verbindbar ist. Jeder Betriebsstromzweig 15a, 15b, 15c, 15d kann somit entweder mit dem ersten Abschaltzweig 14 oder mit dem zweiten Abschaltzweig 23 oder mit beiden verbunden werden. Die Funktionssicherheit des Gleichspannungsnetzknotens ist somit noch weiter erhöht. Durch den zweiten Abschaltzweig 23 ergibt sich der Vorteil, dass beide Sammelschienensysteme 17 und 19 völlig unabhängig voneinander betrieben werden können. Weitere Vorteile würden sich ergeben, wenn durch zusätzliche in Figur 5 nicht dargestellte mechanische Schalter noch die Möglichkeit geschaffen wird, beide Abschaltzweige 14 und 23 an eine gemeinsame Sammelschiene 17 oder 19 zu legen, so dass es jederzeit möglich ist, jederzeit zwei Leitungsströme unabhängig voneinander und egal an welcher Sammelschiene der betreffende Abzweig angeschlossen ist, abzuschalten. Auch hier gilt wieder, dass wenn beide Sammelschienen 17, 19 gleichzeitig mit einem Abzweig verbunden sind, also beispielsweise wenn der mechanische Schalter 5a des Ersatzbetriebsstromzweiges 20a und der mechanische Schalter 5a des Betriebsstromzweiges 15a beide geschlossen sind, sowohl der Ersatzparallelschalter 24a als auch der Parallelschalter 16a geschlossen werden müssen, um den Fehlerstrom erfolgreich abschalten zu können.

Die in den Figuren 4 und 5 gezeigten Ausführungsbeispiele weisen jeweils zwei Sammelschienen 17, 19 auf. Dies erscheint gegenüber dem in Figur 3 gezeigten Ausführungsbeispiel aufwändiger. Muss jedoch die Vorrichtung 13 gemäß Figur 3 gewartet werden oder ist diese aus anderen Gründen nicht einsetzbar, so muss der komplette Gleichspannungsknoten außer Betrieb genommen werden oder aber der Gleichspannungsknoten wird ohne die Möglichkeit betrieben, fehlerhafte Leitungen vom Knoten trennen zu können. Beide Szenarien sind für den Betreiber eines Gleichspannungsnetzes nicht hinnehmbar. Aus diesem Grunde ist es zweckmäßig, einen weiteren Abschaltzweig vorzusehen.

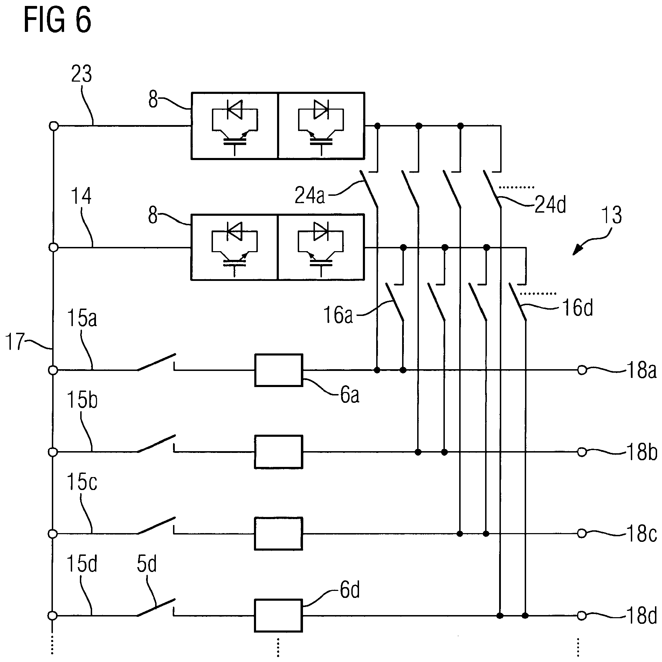

Ein weiteres Ausführungsbeispiel der erfindungsgemäßen Vorrichtung 13, die einen ersten Abschaltzweig 14 sowie einen zweiten Abschaltzweig 23 aufweist, ist in Figur 6 gezeigt. In Figur 6 ist jedoch lediglich eine Sammelschiene vorgesehen, die sowohl mit dem ersten Abschaltzweig 14 als auch mit dem zweiten Abschaltzweig 23 verbunden ist. Wie in Figur 5 ist auch bei dem in Figur 6 gezeigten Ausführungsbeispiel jeder Betriebsstromzweig 15 einmal über einen mechanischen Parallelschalter 16 mit dem ersten Abschaltzweig 14 sowie über einen Ersatzparallelschalter 24 mit dem zweiten Abschaltzweig 23 verbindbar. Gemäß dieser vorteilhaften Ausgestaltung können somit zwei Abzweige gleichzeitig abgeschaltet werden. Darüber hinaus können die Leistungsschalteinheiten 8 des jeweiligen Abschaltzweiges 14 oder 23 durch den abwechselnden Betrieb weniger stark belastet werden. Darüber hinaus ist auch eine gewisse Redundanz und somit erhöhte Sicherheit aufgrund der doppelten Ausführung der mechanischen Schalter bereitgestellt.

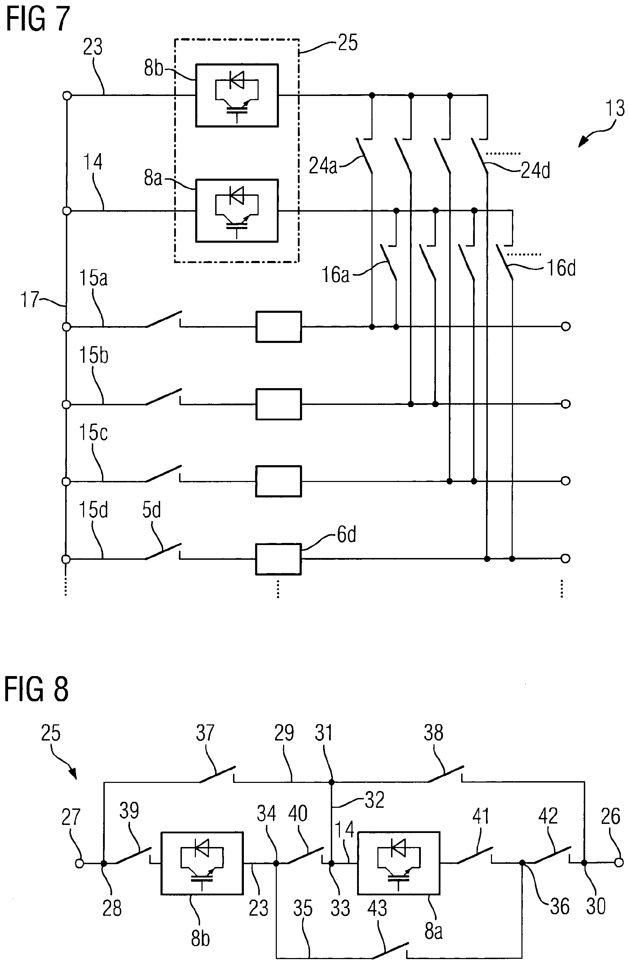

Figur 7 zeigt ein weiteres Ausführungsbeispiel der erfindungsgemäßen Vorrichtung 13, wobei jedoch die Leistungsschalteinheiten lediglich als unidirektionale Leistungsschalteinheiten 8a und 8b ausgestaltet sind. Sie sind in der Lage, Ströme in beiden Richtungen zu führen. Abgeschaltet werden können grundsätzlich nur Ströme in einer Richtung, die in Figur 7 von links nach rechts über die Leistungsschalteinheit 8 fließen.

In Figur 7 ist jedoch durch die gestrichelte Linie eine Anordnung von mechanischen Schaltern und Überbrückungszweigen 25 schematisch angedeutet, die in Figur 8 genauer dargestellt ist. Die Anordnung von mechanischen Schaltern und Überbrückungszweigen 25 weist wieder einen ersten Abschaltzweig 14 mit einer unidirektionalen Leistungsschalteinheit 8a sowie einen zweiten Abschaltzweig 23 mit einer unidirektionalen Leistungsschalteinheit 8b auf. Der erste Abschaltzweig 14 ist mit der Anschlussklemme 26 mit einem Kontaktstück eines Parallelschalters oder Ersatzparallelschalters verbunden, wohingegen die Sammelschienenanschlussklemme 27 mit der Sammelschiene 17, wie in Figur 7 gezeigt, verbunden ist. Von einem ersten Verzweigungspunkt 28 erstreckt sich ein Gesamtüberbrückungszweig 29 zu einem zweiten Verzweigungspunkt 30. Von einem dritten Verzweigungspunkt 31 erstreckt sich ein Verbindungszweig 32 zu einem vierten Verzweigungspunkt 33. Von einem fünften Verzweigungspunkt 34 erstreckt sich ein Einzelüberbrückungszweig 35 zu dem sechsten Verzweigungspunkt 36. Im Gesamtüberbrückungszweig 29 ist zwischen dem ersten Verzweigungspunkt 28 und dem dritten Verzweigungspunkt 31 ein mechanischer Schalter 37 angeordnet. Ein zweiter mechanischer Schalter 38 befindet sich zwischen dem dritten Verzweigungspunkt 31 und dem zweiten Verzweigungspunkt 30 im Gesamtüberbrückungszweig 29. Im zweiten Abschaltzweig 23 ist zwischen dem ersten Verzweigungspunkt 28 und der Leistungsschalteinheit 8b ein weiterer mechanischer Schalter 39 angeordnet. Zwischen dem fünften Verzweigungspunkt 34 und dem vierten Verzweigungspunkt 33 ist der mechanische Schalter 40 vorgesehen, wobei ein weiterer mechanischer Schalter 41 zwischen der Leistungsschalteinheit 8a und dem sechsten Verzweigungspunkt 36 vorgesehen ist. Schließlich ist ein mechanischer Schalter 42 zwischen dem sechsten Verzweigungspunkt 36 und dem zweiten Verzweigungspunkt 36 angeordnet. Ein letzter mechanischer Schalter 43 ist im Einzelüberbrückungszweig 35 angeordnet.

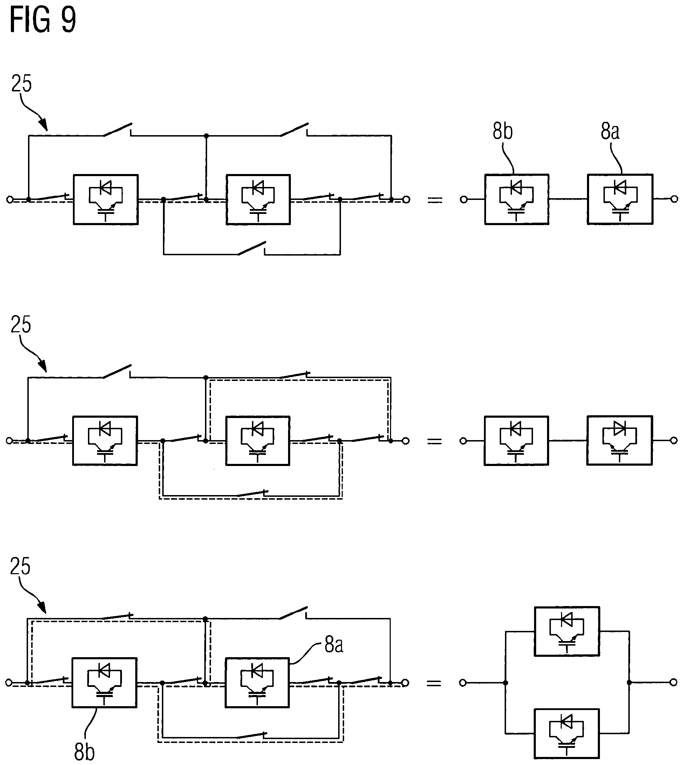

Figur 9 zeigt verschiedene Schalterstellungen der Anordnung von mechanischen Schaltern und Überbrückungszweigen 25. In der oberen Darstellung sind die mechanischen Schalter 39, 40, 41 und 42 geschlossen, wohingegen die mechanischen Schalter 37, 38 und 43 geöffnet sind. Somit sind, wie mit dem Gleichheitszeichen angedeutet, die unidirektionalen Leistungsschalteinheiten 8a und 8b in Reihe zueinander geschaltet. In der mittigen Darstellung der Figur 9 sind die Schalter 39, 43, 41 und 38 geschlossen, wohingegen die Schalter 37, 40 und 42 geöffnet sind. Bei diesen Schalterstellungen sind die Leistungsschalteinheiten 8a und 8b gegensinnig in Reihe geschaltet, wobei die Schalteranordnung 8a die Ströme der einen und die Leistungsschalteinheit 8b in der entgegengesetzten Richtung abgeschaltet kann. Somit können Ströme in beiden Richtungen geführt und abgeschaltet werden. Es ist in dieser Schalterstellung ein so genannter bidirektionaler Leistungsschalter bereitgestellt.

In der in Figur 9 unten dargestellten Schalterstellung sind die Schalter 39, 43, 42 sowie 37 und 41 geschlossen. Die Schalter 38 und 40 befinden sich jedoch in ihrer geöffneten Stellung. In diesem Zustand der Anordnung 25 ist eine Parallelschaltung beider Leistungsschalteinheiten 8a und 8b geschaffen.

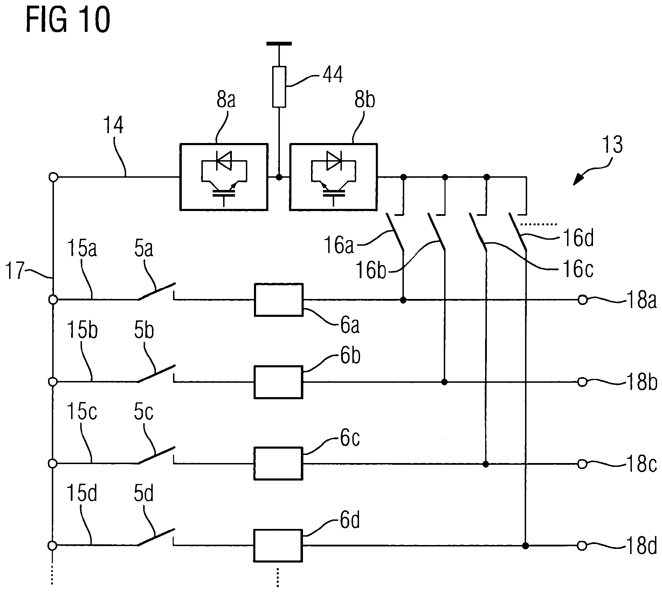

Figur 10 zeigt eine Möglichkeit, wie die Leistungsschalteinheiten 8a und 8b in Betrieb genommen werden können. Dies ist insbesondere dann durchzuführen, wenn die Submodule als Halb- oder Vollbrückenschaltungen ausgebildet sind und jeweils einen aufzuladenden Energiespeicher aufweisen. In diesem Falle ist ein so genannter Ladewiderstand 44 besonders zweckmäßig, der auf der einzigen Seite an dem ersten Abschaltzweig 14 angeschlossen und auf der anderen Seite entweder mit dem Erdpotenzial oder mit dem anderen Pol des Gleichspannungsnetzes verbunden ist.

Abschließend sei darauf hingewiesen, dass die hier figürlich gezeigten Ausführungsbeispiele als so genannte "Single-Line"-Darstellungen zu verstehen sind. Bei Gleichspannungsnetzen ist jedoch davon auszugehen, dass jede der gezeigten Topologien zweimal vorhanden ist, nämlich einmal für den positiven und einmal für den negativen Pol des Gleichspannungsnetzes.

## Patentansprüche

1. Vorrichtung (13) zum Schalten von Gleichströmen in Abzweigen eines Gleichspannungsnetzknotens mit
- einem ersten Abschaltzweig (14), in dem eine Leistungsschalteinheit (8) angeordnet ist, die eine Reihenschaltung von zweipoligen Submodulen mit wenigstens einem ein- und abschaltbaren Leistungshalbleiterschalter (9) aufweist,
- einem Betriebsstromzweig (15a), in dem ein mechanischer Schalter (5) angeordnet ist, und
- einem elektronischen Hilfsschalter (6), der in dem Betriebsstromzweig (15a) in Reihe zu dem mechanischen Schalter (5) angeordnet ist,
**dadurch gekennzeichnet, dass**
- der Betriebsstromzweig (15a) über einen Parallelschalter (16a) parallel zum Abschaltzweig (14) geschaltet ist,
- der Betriebsstromzweig (15a) mit einem Abzweiganschluss (18a) zum Anschluss eines zugeordneten Abzweiges des Gleichspannungsnetzknotens verbunden ist,
- wenigstens ein weiterer Betriebsstromzweig (15b) vorgesehen ist, der über einen weiteren Parallelschalter dem ersten Abschaltzweig (14) parallel geschaltet ist,
- in jedem Betriebsstromzweig (15) ein mechanischer Schalter (5) und in Reihe dazu ein elektronischer Hilfsschalter (6) angeordnet ist,
- jeder Betriebsstromzweig (15) mit einem Abzweiganschluss (18) zum Anschluss eines zugeordneten Abzweiges des Gleichspannungsnetzknotens verbunden ist,
- jeder Betriebsstromzweig (15) über einen Parallelschalter (16) dem Abschaltzweig (14) parallel geschaltet ist,
- die Submodule der Leistungsschalteinheit (8) jeweils einen Energiespeicher aufweisen und
- die Submodule der Leistungsschalteinheit (8) jeweils eine Halb- oder Vollbrückenschaltung ausbilden, wobei bei der Halbbrückenschaltung dem Energiespeicher eine Reihenschaltung aus zwei Leistungshalbleiterschaltern parallel geschaltet ist, eine Submodulanschlussklemme des Submoduls mit dem Potenzialpunkt zwischen den Leistungshalbleiterschaltern der Reihenschaltung verbunden ist, und eine zweite Submodulanschlussklemme mit einem der Pole des Energiespeichers verbunden ist, oder wobei bei der Vollbrückenschaltung zwei Reihenschaltungen von jeweils zwei Leistungshalbleiterschaltern vorgesehen sind, wobei eine Submodulanschlussklemme mit dem Potenzialpunkt zwischen den Leistungshalbleiterschaltern der ersten Reihenschaltung und eine zweite Submodulanschlussklemme mit dem Potenzialpunkt zwischen den Leistungshalbleiterschaltern der zweiten Reihenschaltung verbunden ist.

2. Vorrichtung (13) nach Anspruch 1,
**dadurch gekennzeichnet, dass**
die Submodule der Leistungsschalteinheit (8) zumindest teilweise jeweils einen ein- und abschaltbaren Leistungshalbleiterschalter (9) und eine gegensinnig parallel hierzu geschaltete Freilaufdiode (10) aufweisen.

3. Vorrichtung (13) nach einem der Ansprüche 1 oder 2,
**dadurch gekennzeichnet, dass**
die Submodule der Leistungsschalteinheit (8) zwei Gruppen (8a,8b) mit jeweils gleich orientierten Durchlassrichtungen ihrer Leistungshalbleiterschalter ausbilden, wobei die Leistungshalbleiterschalter der einen Gruppe (8a) entgegengesetzt zu den Leistungshalbleiterschaltern der anderen Gruppe (8b) orientiert sind.

4. Vorrichtung (13) nach einem der Ansprüche 1 bis 3,
**dadurch gekennzeichnet, dass**
der elektronische Hilfsschalter (6) wenigstens ein zweipoliges Submodul aufweist, das einen Energiespeicher aufweist und eine Halb- oder Vollbrückenschaltung ausbildet.

5. Vorrichtung (13) nach einem der vorhergehenden Ansprüche,
**dadurch gekennzeichnet, dass**
die Leistungsschalteinheit (8) Varistoren und/oder Ableiter in Parallelschaltung zu wenigstens einem Submodul aufweist.

6. Vorrichtung (13) nach einem der vorhergehenden Ansprüche,
**dadurch gekennzeichnet, dass**
der Abschaltzweig (14) über eine erste Sammelschiene (17) mit jedem Betriebsstromzweig (15) verbunden ist.

7. Vorrichtung (13) nach Anspruch 6,
**dadurch gekennzeichnet, dass**
eine zweite Sammelschiene (19) vorgesehen ist, die über Ersatzbetriebsstromzweige (20) mit jedem Betriebsstromzweig (15) verbunden ist.

8. Vorrichtung (13) nach Anspruch 7,
**dadurch gekennzeichnet, dass**
die erste Sammelschiene (17) und die zweite Sammelschiene (19) jeweils über einen Sammelschienenschalter (21,22) mit dem ersten Abschaltzweig (14) verbunden sind.

9. Vorrichtung (13) nach einem vorhergehenden Ansprüche,
**dadurch gekennzeichnet, dass**
ein zweiter Abschaltzweig (23) vorgesehen ist, in dem eine zum Schalten von Fehlerströmen eingerichtete Leistungsschalteinheit angeordnet ist, wobei jeder Betriebsstromzweig (15) über einen mechanischen Ersatzparallelschalter (24) mit dem zweiten Abschaltzweig (23) verbindbar ist.

10. Vorrichtung (13) nach Anspruch 9,
**dadurch gekennzeichnet, dass**
der erste und der zweite Abschaltzweig (14,23) mit der gleichen Sammelschiene (17) verbunden sind.

11. Vorrichtung (13) nach einem der vorhergehenden Ansprüche,
**dadurch gekennzeichnet, dass**
der erste Abschaltzweig (14) und der zweite Abschaltzweig (23) über eine Anordnung von mechanischen Schaltern und Überbrückungszweigen (25) so miteinander verknüpfbar sind, dass ihre Leistungsschalteinheiten (8a,8b) gleich- oder gegensinnig in Reihe oder parallel geschaltet sind.

## Claims

1. Apparatus (13) for switching direct currents in branches of a DC voltage network node having
- a first switch-off branch (14), in which a power switching unit (8) is arranged, which has a series circuit of two-pole submodules having at least one power semiconductor switch (9) that can be switched on and off,
- an operating current branch (15a), in which a mechanical switch (5) is arranged, and
- an electronic auxiliary switch (6), which is arranged in the operating current branch (15a) in series with the mechanical switch (5),
**characterized in that**
- the operating current branch (15a) is connected in parallel with the switch-off branch (14) by means of a parallel switch (16a),
- the operating current branch (15a) is connected to a branch connection (18a) for connection of an associated branch of the DC voltage network node,
- at least one further operating current branch (15b) is provided, which is connected in parallel with the first switch-off branch (14) by means of a further parallel switch,
- a mechanical switch (5) and an electronic auxiliary switch (6) in series therewith is arranged in each operating current branch (15),
- each operating current branch (15) is connected to a branch connection (18) for connection of an associated branch of the DC voltage network node,
- each operating current branch (15) is connected in parallel with the switch-off branch (14) by means of a parallel switch (16),
- the submodules of the power switching unit (8) each have an energy store, and
- the submodules of the power switching unit (8) each form a half-bridge circuit or a full-bridge circuit, wherein, in the case of the half-bridge circuit, a series circuit composed of two power semiconductor switches is connected in parallel with the energy store, a submodule connection terminal of the submodule is connected to the potential point between the power semiconductor switches of the series circuit, and a second submodule connection terminal is connected to one of the poles of the energy store, or wherein, in the case of the full-bridge circuit, two series circuits of in each case two power semiconductor switches are provided, wherein a submodule connection terminal is connected to the potential point between the power semiconductor switches of the first series circuit and a second submodule connection terminal is connected to the potential point between the power semiconductor switches of the second series circuit.

2. Apparatus (13) according to Claim 1, **characterized in that** at least some of the submodules of the power switching unit (8) in each case have a power semiconductor switch (9) that can be switched on and off and a freewheeling diode (10) connected in parallel therewith and in the opposite direction thereto.

3. Apparatus (13) according to either of Claims 1 and 2, **characterized in that** the submodules of the power switching unit (8) form two groups (8a, 8b) each having identically oriented forward directions of their power semiconductor switches, wherein the power semiconductor switches of the one group (8a) are oriented opposite to the power semiconductor switches of the other group (8b).

4. Apparatus (13) according to one of Claims 1 to 3, **characterized in that** the electronic auxiliary switch (6) has at least one two-pole submodule, which has an energy store and forms a half-bridge circuit or full-bridge circuit.

5. Apparatus (13) according to one of the preceding claims, **characterized in that** the power switching unit (8) has varistors and/or arresters connected in parallel with at least one submodule.

6. Apparatus (13) according to one of the preceding claims, **characterized in that** the switch-off branch (14) is connected to each operating current branch (15) by means of a first busbar (17).

7. Apparatus (13) according to Claim 6, **characterized in that** a second busbar (19) is provided, which is connected to each operating current branch (15) by means of substitute operating current branches (20).

8. Apparatus (13) according to Claim 7, **characterized in that** the first busbar (17) and the second busbar (19) are each connected to the first switch-off branch (14) by means of a busbar switch (21, 22).

9. Apparatus (13) according to one of the preceding claims, **characterized in that** a second switch-off branch (23) is provided, in which a power switching unit configured for switching fault currents is arranged, wherein each operating current branch (15) can be connected to the second switch-off branch (23) by means of a mechanical substitute parallel switch (24).

10. Apparatus (13) according to Claim 9, **characterized in that** the first and the second switch-off branch (14, 23) are connected to the same busbar (17).

11. Apparatus (13) according to one of the preceding claims, **characterized in that** the first switch-off branch (14) and the second switch-off branch (23) can be linked to one another by means of an arrangement of mechanical switches and bypass branches (25) in such a way that their power switching units (8a, 8b) are connected in series or in parallel and in the same or the opposite direction.

## Revendications

1. Montage (13), pour faire passer des courants continus dans des dérivations d'un noeud de réseau de tension continue, comprenant
- une première branche (14) d'interruption, dans laquelle est montée une unité (18) de disjonction, qui a un circuit série de sous-modules bipolaires, ayant au moins un interrupteur (9) à semiconducteur de puissance pouvant être fermé et ouvert,
- une branche (15a) de courant d'alimentation, dans laquelle est montée un interrupteur (5) mécanique, et
- un interrupteur (6) auxiliaire électronique, qui est monté dans la branche (15a) de courant de fonctionnement en série avec l'interrupteur (5) mécanique,
**caractérisé en ce que**
- la branche (15a) de courant de fonctionnement est, par un interrupteur (16a) en parallèle, montée en parallèle à la branche (14) d'interruption,
- la branche (15a) de courant de fonctionnement est reliée à une borne (18a) de dérivation, pour le raccordement d'une dérivation associée du noeud de réseau de tension continue,
- il est prévu au moins une autre branche (15b) de courant de fonctionnement, qui, par un autre interrupteur en parallèle, est montée en parallèle à la première branche (14) d'interruption,
- dans chaque branche (15) de courant de fonctionnement, est monté un interrupteur (5) mécanique et, en série avec lui, un interrupteur (6) auxiliaire électronique,
- chaque branche (15) de courant de fonctionnement est reliée à une borne (18) de dérivation, pour le raccordement d'une dérivation associée du noeud de réseau de tension continue,
- chaque branche (15) de courant de fonctionnement est montée, par un interrupteur (16) en parallèle, en parallèle à la branche (14) d'interruption,
- les sous-modules de l'unité (8) de disjonction ont chacun un accumulateur d'énergie et
- les sous-modules de l'unité (8) de disjonction constituent chacun un circuit en demi-pont ou en pont complet, dans lequel, pour le circuit en demi-pont, il est monté, en parallèle à l'accumulateur d'énergie, un circuit série composé de deux interrupteurs à semiconducteur de puissance, une borne de connexion du sous-module est reliée au point de potentiel entre les interrupteurs à semiconducteur de puissance du circuit série, et une deuxième borne de connexion du sous-module est reliée à l'un des pôles de l'accumulateur d'énergie, ou dans lequel, dans le circuit à pont complet, il est prévu deux circuits série de chacun deux interrupteurs à semiconducteur de puissance, une borne de connexion de sous-module étant reliée au point de potentiel entre les interrupteurs à semiconducteur de puissance du premier circuit série et une deuxième borne de connexion de sous-module au point de potentiel entre les interrupteurs à semiconducteur de puissance du deuxième circuit série.

2. Montage (13) suivant la revendication 1,
**caractérisé en ce que**
les sous-modules de l'unité (8) de disjonction ont, au moins en partie, chacun un interrupteur (9) à semiconducteur de puissance pouvant être fermé et ouvert et une diode (10) à roue libre montée tête-bêche et en parallèle à celui-ci.

3. Montage (13) suivant l'une des revendications 1 ou 2,
**caractérisé en ce que**
les sous-modules de l'unité (8) de disjonction constituent deux groupes (8a, 8b), ayant chacun des sens passant, orientés pareillement de leur interrupteur à semiconducteur de puissance, les interrupteurs à semiconducteur de puissance de l'un des groupes (8a) étant orientés en sens contraire aux interrupteurs à semiconducteur de puissance de l'autre groupe (8b).

4. Montage (13) suivant l'une des revendications 1 à 3,
**caractérisé en ce que**
l'interrupteur (6) auxiliaire électronique a au moins un sous-module bipolaire, qui a un accumulateur d'énergie et qui constitue un circuit en demi-pont ou en pont complet.

5. Montage (13) suivant l'une des revendications précédentes,
**caractérisé en ce que**
l'unité (8) de disjonction a des varistances et/ou des parafoudres suivant un circuit en parallèle à au moins un sous-module.

6. Montage (13) suivant l'une des revendications précédentes, **caractérisé en ce que**
la branche (14) d'interruption est reliée à chaque branche (15) de courant de fonctionnement par une première barre (17) collectrice.

7. Montage (13) suivant la revendication 6,
**caractérisé en ce que**
il est prévu une deuxième barre (19) collectrice, qui est reliée à chaque branche (15) de courant d'alimentation par des branches (20) de courant de fonctionnement supplémentaires.

8. Montage (13) suivant la revendication 7,
**caractérisé en ce que**
la première branche (17) collectrice et la deuxième branche (19) collectrice sont reliées chacune à la première branche (14) d'interruption par un interrupteur (21, 22) de barre collectrice.

9. Montage (13) suivant l'une des revendications précédentes,
**caractérisé en ce que**
il est prévu une deuxième branche (23) d'interruption, dans laquelle est montée une unité de disjonction, conçue pour faire passer des courants de défaut, chaque branche (15) de courant d'alimentation pouvant, par un interrupteur (24) mécanique de remplacement en parallèle, être reliée à la deuxième branche (23) d'interruption.

10. Montage (13) suivant la revendication 9,
**caractérisé en ce que**
la première et la deuxième branches (14, 23) d'interruption sont reliées à la même barre (17) collectrice.

11. Montage (13) suivant l'une des revendications précédentes,
**caractérisé en ce que**
la première branche (14) d'interruption et la deuxième branche (23) d'interruption peuvent être combinées l'une à l'autre par un montage d'interrupteur mécanique et de branche (25) de shuntage, de manière à ce que leurs unités (8a, 8b) de disjonction soient montées en série ou en parallèle dans le même sens ou dans le sens contraire.
